Europäisches Patentamt

European Patent Office

Office européen des brevets

(19)

(11) Publication number: **0 104 752 B1**

(12) **EUROPEAN PATENT SPECIFICATION**

(45) Date of publication of patent specification: 25.02.87

(51) Int. Cl.⁴: **G 05 F 3/20**

(21) Application number: 83304803.6

(22) Date of filing: 19.08.83

(54) A bias voltage supply circuit.

(30) Priority: 23.08.82 JP 145737/82

(43) Date of publication of application:
04.04.84 Bulletin 84/14

(45) Publication of the grant of the patent:
25.02.87 Bulletin 87/09

(84) Designated Contracting States:
DE FR GB

(56) References cited:
US-A-3 660 694
US-A-3 939 434
US-A-4 057 789

IBM TECHNICAL DISCLOSURE BULLETIN, vol.
25, no. 7A, December 1982, page 3548, New
York, US. A. Z. WALACH: "IC current source"

(73) Proprietor: Kabushiki Kaisha Toshiba
72, Horikawa-cho Saiwai-ku
Kawasaki-shi Kanagawa-ken 210 (JP)

(72) Inventor: Kuwahara, Hisao c/o Patent Division
Tokyo Shibaura Denki K.K. 72, Horikawa-cho
Saiwai-ku Kawasaki-shi Kanagawa-ken (JP)

(74) Representative: Newstead, Michael John et al
Haseltine Lake & Co. 28 Southampton Buildings
Chancery Lane
London, WC2A 1AT (GB)

## Description

The present invention relates to a bias voltage supply circuit, and more particularly to a semiconductor bias voltage supply circuit adapted for providing an electrical bias with a constant output voltage characteristic less affected by output current.

Constant bias voltage supply circuits are very useful in integrated circuit (IC) form. Many forms of constant bias voltage supply circuits have been developed. In constant bias voltage supply circuits, it is required that the operating bias voltage is not changed by a variation in the output current.

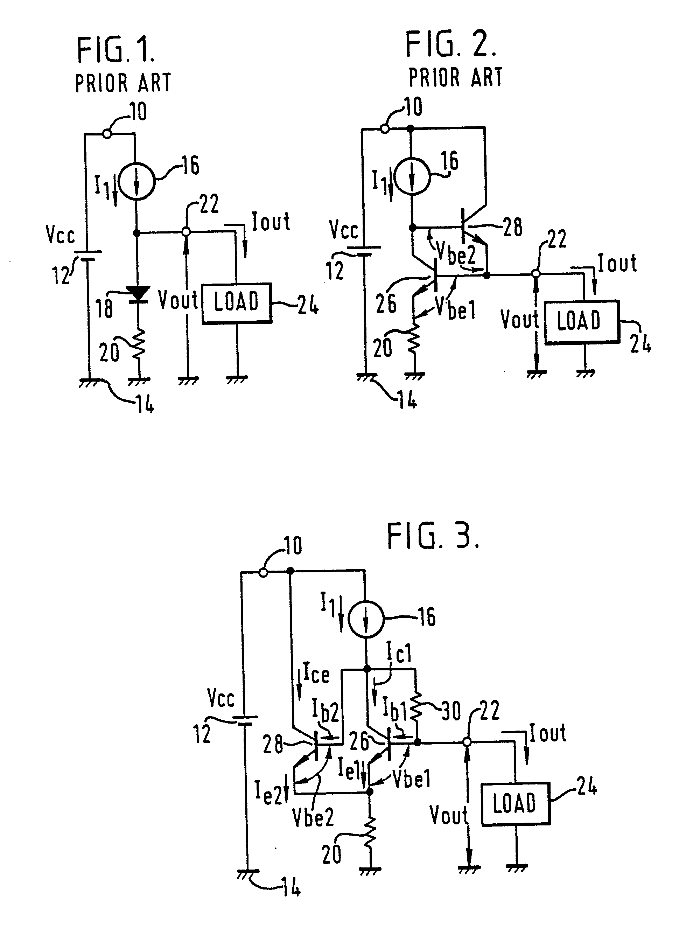

As is well known, a principal example of bias voltage supply circuit in common use in, for example, transistor circuits can be implemented as shown in Figure 1. In Figure 1, a DC power supply terminal 10 is connected to the positive terminal of a battery 12 whose negative terminal is connected to reference potential terminal 14. DC power supply terminal 10 is connected via a DC current source 16, a diode 18 and a resistor 20 to terminal 14. An output terminal 22 is connected to a circuit connection between DC current source 16 and diode 18. A load 24 is connected between output terminal 22 and reference potential terminal 14. Diode 18 can be realised by a diode-connected transistor; and DC current source 16 can merely be a resistor or it can be a constant-current circuit incorporating a transistor and resistors.

If the output current of DC current source 16 is taken as I1, the load current flowing to load 24 as Iout, and the forward voltage of diode 18 as Vf, then output voltage Vout is as follows.

$$Vout = Vf + (I1 - Iout) \ R1 \tag{1}$$

where R1 is the resistance of resistor 20.

If, in this formula, the forward current of diode 18 is taken as Id1, and its reverse saturation current as Isd1, we obtain the following.

$$Vf = Vt \cdot \ln\left(\frac{Id1}{Isd1}\right) = Vt \cdot \ln\left(\frac{I1 - Iout}{Isd1}\right)$$

where,

Vt=thermal voltage=Kt/q,
k=Boltzmann's constant,
T=absolute temperature,
q=electron charge.

Then, equation (1) is transformed as following.

$$Vout = Vt \cdot \ln\left(\frac{I1 - Iout}{Isd1}\right) + (I1 - Iout) \cdot R1 \tag{2}$$

When the ambient temperature is 27°C, Vt=26mV, and if the output voltage Vout(0) when there is no load (i.e. when Iout=0A (ampere) and assuming that I1=100 µA (micro-ampere), R1=3kΩ and Isd1=2.3×10 µA) is calculated from formula (2), we have the following.

$$Vout(0) = Vt \cdot \ln\left(\frac{I1}{Isd1}\right) + I1 \cdot R1 = 0.026 \cdot \ln\left(\frac{100 \times 10^{-6}}{2.03 \times 10^{-16}}\right) + 100 \times 10^{-6} \times 3 \times 10^{3}$$

$$\fallingdotseq 0.700 + 0.300 = 1.000V \ (volt)$$

Next, if output voltage Vout(50) when there is a load current of 50µA is calculated from formula (1), we have the following.

$$Vout(50) = 0.026 \cdot \ln\left(\frac{(100-50) \times 10^{-6}}{2.03 \times 10^{-16}}\right) + (100-50) \times 10^{-6} \times 3 \times 10^{3}$$

$$= 0.682 + 0.150 = 0.832V$$

In other words, whereas output voltage Vout(0) when there is no load is 1.000V, output voltage Vout(50) when there is a load current of 50µA, which is half of current I1 of DC current source 14, is 0.832V, representing a fall of 0.178V. In brief, the problem with the bias voltage supply circuit of Figure 1 is that fluctuations in the load current give rise to large fluctuations in output voltage Vout.

This had led to the use, in cases where the load fluctuations are considerable, of another example of bias voltage supply circuit as shown in Figure 2, in which transistors 26, 28 are incorporated. In this case,

2

considering that the relationship of base current Ib1 of transistor 26 and load current Iout is Ib1≪Iout, and taking the base-emitter voltage, emitter current, and reverse saturation current of transistor 26 as Vbe1, Ie1 and IsQ1 respectively, output voltage Vout is as follows.

$$Vout = Vbe1 + Ie1 \cdot R1$$

where
R1 is the resistance of resistor 20

$$= Vt \cdot \ln\left(\frac{Ie1}{IsQ1}\right) + Ie1 \cdot R1 \tag{3}$$

If the grounded emitter circuit current amplification factors of transistors 26, 28 are taken as β1, β2, respectively, we have the following.

$$Ie1 = Ic1 + Ib1 = Ic1 \cdot \left(1 + \frac{1}{\beta 1}\right)$$

where Ic1 = I1 − Ib2. Then

$$Ie1 = (I1 - Ib2) \cdot \left(1 + \frac{1}{\beta 1}\right) = I1 \cdot \left(1 + \frac{1}{\beta 1}\right) - Ib2 \cdot \left(1 + \frac{1}{\beta 1}\right)$$

therefore,

$$Ie1 = I1 \cdot \left(1 + \frac{1}{\beta 1}\right) - \frac{1}{(1 + \beta 2)} \cdot \left(1 + \frac{1}{\beta 1}\right)$$

If β2 is assumed to be very large, then we have

$$Ie1 \cong I1 \cdot \left(1 + \frac{1}{\beta 1}\right) \tag{4}$$

with emitter current Ie1 ceasing to be influenced by load current Iout.

This being so, output voltage Vout expressed by formula (4) given above also ceases to be affected by load current Iout.

In the bias voltage supply circuit of Figure 2, for the formula (4) to be applicable, grounded emitter circuit current amplification factor β2 of transistor 28 must be very large. In other words, the magnitude of the changes in output voltage Vout of the bias voltage supply circuit of Figure 2 in response to fluctuations in load current Iout depends to a large extent on the current-amplification action of transistor 28. But for transistor 28 to provide this current-amplification action, the base-emitter junction of transistor 28 must be biased in the forward direction. This means that voltage Vcc at DC power supply terminal 10 must be

$$Vcc \geqq Vout + Vbe2$$

(where Vbe2 = base-emitter voltage of transistor 28), which implies a high consumption of electric power. It may be noted here that voltage Vcc of DC power supply terminal 10 in the bias voltage supply circuit of Figure 1 need be only Vcc≧Vout.

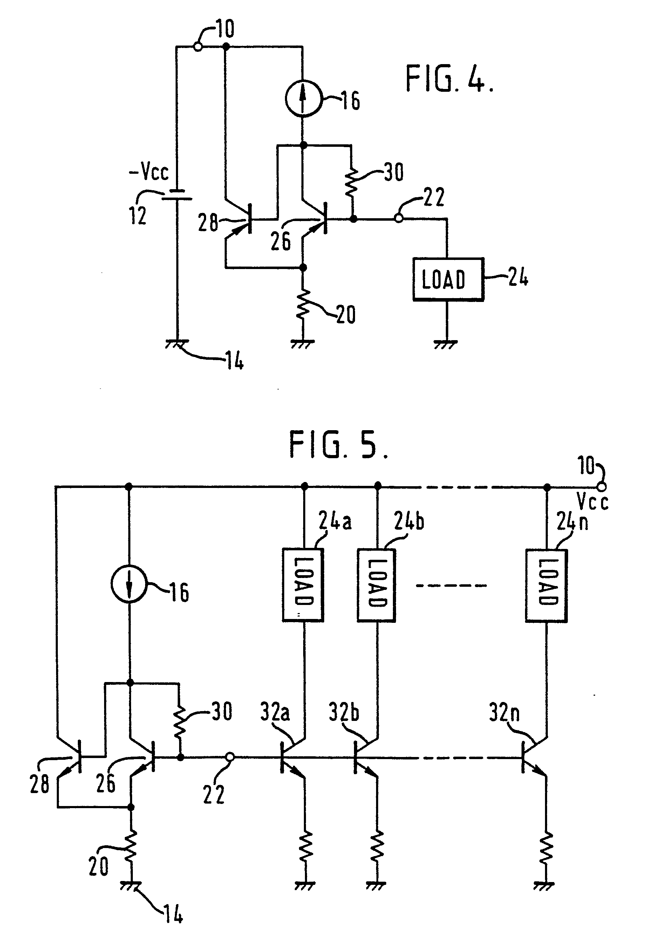

Another bias voltage supply circuit is known from Figure 4 of US—A—4 057 789.

An object of the invention is to provide a bias voltage supply circuit of very high quality, which can operate at a low voltage, and in which the regulation of the output voltage with fluctuations in the load current is small.

According to the present invention, there is provided a bias voltage supply circuit comprising:
a DC power supply terminal;
a DC current source;
a first transistor connected at its collector to said DC power supply terminal via said DC current source;
a resistor connected between the emitter of said first transistor and a reference potential terminal;
a second transistor connected by its collector-emitter circuit in parallel with the series circuit of said DC current source and said first transistor, the base of said second transistor being connected to the collector of said first transistor; and

3

an output terminal connected to the base of said first transistor, characterised in that the circuit further comprises:

a second resistor connected in parallel with the collector-base circuit of said first transistor.

The present invention will now be described by way of example with reference to Figures 3 to 5 of the accompanying drawings, in which:—

Figure 3 is a circuit diagram of an embodiment of a bias voltage supply circuit according to the present invention; and

Figures 4 and 5 are circuit diagrams of modified forms of the embodiment of Figure 3.

In Figures 3 to 5, items which correspond to items in Figures 1 and 2 are given the same reference numerals as in Figures 1 and 2.

Referring to Figure 3, a bias voltage supply circuit comprises DC power supply terminal 10 connected to a positive terminal of battery 12 whose negative terminal is connected to reference potential terminal 14. DC power supply terminal 10 is connected to reference potential terminal 14 via DC current source 16, first NPN transistor 26 and resistor 20 to terminal 14. Second NPN transistor 28 is connected in parallel with the series circuit of DC current source 16 and first NPN transistor 26. The emitters of the transistors 26, 28 are connected together, and the base of second NPN transistor 28 is connected to the collector of first NPN transistor 26. A resistor 30 is connected in parallel with the collector-base circuit of first transistor 26, and the base of first transistor 26 is connected to output terminal 22 of the bias voltage supply circuit. To output terminal 22, load 24 is connected.

We now seek output voltage Vout in this kind of configuration. In this case, so as to simplify the analysis, it is assumed that grounded emitter circuit current amplification factors $\beta1$, $\beta2$ of transistors 26, 28 are very large, and that base currents Ib1, Ib2 can be ignored in relation to collector currents Ic1, Ic2 (the emitter currents being Ie1, Ie2). The following, that is to say, is assumed.

$$Ie1 \fallingdotseq Ic1; \quad Ie2 \fallingdotseq Ic2$$

It is also assumed that base currents Ib1, Ib2 of transistors 26, 28 are so small in relation also to load current Iout that they can be ignored. It is also assumed that the characteristics of transistors 26, 28 are exactly matched. If the base-emitter voltage of transistor 26 is taken as Vbe1, output voltage Vout at output terminal 22 is as follows.

$$Vout = Vbe1 + (Ie1 + Ie2) \cdot R1 \tag{5}$$

where R1 is the resistance of resistor 20.

If Ie2/Ie1=K, and the current of DC current source 16 and the output current of the bias voltage supply circuit are taken as I1 and Iout, we have the following.

$$Ie1 = I1 - Iout; \quad Ie2 = K \cdot (I1 - Iout)$$

If the base-emitter voltage of transistor 28 is taken as Vbe2, and voltage difference $\Delta Vbe$ between base-emitter voltages Vbe2 and Vbe1 is sought, we find that

$$\Delta Vbe = Vbe2 - Vbe1 = Vt \cdot \ln K = Iout \cdot R2$$

where Vt=thermal voltage (as defined above) and that

$$K = e^{\left(\dfrac{Iout \cdot R2}{Vt}\right)}$$

where R2 is the resistance of resistor 30.

If the reverse saturation current of transistor 26 is taken as IsQ1, the above equation (5) is transformed as follows.

$$Vout = Vbe1 + (Ie1 + Ie2) \cdot R1$$

$$= Vt \cdot \ln\left(\frac{Ie1}{IsQ1}\right) + \{(I1 - Iout) + K \cdot (I1 - Iout)\} \cdot R1$$

$$= Vt \cdot \ln\left(\frac{I1 - Iout}{IsQ1}\right) + (1 + K) \cdot (I1 - Iout) \cdot R1$$

$$= Vt \cdot \ln\left(\frac{I1 - Iout}{IsQ1}\right) + \left(1 + e^{\frac{(Iout \cdot R2)}{Vt}}\right) \cdot (I1 - Iout) \cdot R1 \tag{6}$$

Using formula (4), when Iout<I1, it is possible to select an appropriate value for resistance R2, so that loaded output voltage Vout(L) when load 24 is connected is equal to non-loaded output voltage Vout(0) (i.e. when Iout=0). That is to say, by the substitution of Iout=0 in formula (6), Vout(0) is as follows.

$$Vout(0)=Vt \cdot \ln(\frac{I1}{IsQ1})+2I1 \cdot R1$$

To find the resistance R2 of resistor 30, set Vout(0)=Vout(L), so that

$$Vt \cdot \ln(\frac{I1}{IsQ1})+2I1 \cdot R1=Vt \cdot \ln(\frac{I1-Iout}{IsQ1})+(1+e^{\frac{(Iout \cdot R2)}{Vt}}) \cdot (I1-Iout) \cdot R1$$

and we therefore have the following.

$$R2=\frac{Vt}{Iout} \cdot \ln \left\{ \frac{Vt \cdot \ln(\frac{I1}{I1-Iout})}{(I1-Iout) \cdot R1}+(\frac{I1+Iout}{I1-Iout}) \right\} \quad (7)$$

If assuming that I1=100µA, Iout=50µA, and R1=1.5kΩ, the value of R2 at which Vout(0)=Vout(L) is calculated from formula (6), we have the following.

$$R2=\frac{0.026}{50 \times 10^{-6}} \cdot \ln \left\{ \frac{0.026 \cdot \ln(\frac{100}{100-50})}{(100-50) \times 10^{-6} \times 1.5 \times 10^{3}}+\frac{100+50}{100-50} \right\} \fallingdotseq 611\Omega$$

The Table below shows the values (calculated by formulae (1) and (6)) of output voltage Vout with load current Iout varied in steps of 10µA within the range −90 µA to 90µA, when

$$I1=100µA, \quad Isd1=2.03 \times 10µA$$

$$R1=3k\Omega$$

in the conventional circuit of Figure 1, and

$$I1=100µA, \quad IsQ1=2.03 \times 10µA$$

$$R1=1.5k\Omega, \quad R2=611\Omega$$

in the embodiment shown in Figure 3.

TABLE

| Load current (Iout) (µA) | Output voltage (Vout) (V) | |
| --- | --- | --- |
| | Fig. 1 | Fig. 3 |
| −90 | 1.287 | 1.036 |
| −80 | 1.255 | 1.026 |
| −70 | 1.225 | 1.018 |
| −60 | 1.192 | 1.011 |
| −50 | 1.161 | 1.005 |
| −40 | 1.129 | 1.001 |
| −30 | 1.097 | 0.998 |
| −20 | 1.065 | 0.998 |
| −10 | 1.032 | 0.997 |
| 0 | 1.000 | 1.000 |
| 10 | 0.967 | 1.003 |
| 20 | 0.934 | 1.006 |
| 30 | 0.901 | 1.009 |
| 40 | 0.861 | 1.007 |
| 50 | 0.831 | 1.000 |
| 60 | 0.796 | 0.982 |
| 70 | 0.759 | 0.947 |
| 80 | 0.718 | 0.885 |
| 90 | 0.670 | 0.779 |

As will be clear from this Table, whereas when in the conventional bias circuit of Figure 1 load current Iout fluctuates within the range −50µA to 50µA the output voltage Vout deviations are within the range +0.161V to −0.169V, in the embodiment shown in Figure 3. The output voltage Vout deviations are only within the narrow range of +0.009V to −0.003V. In comparison with the conventional type of circuit, therefore, fluctuations in output voltage Vout with fluctuations in load current Iout are minimal.

Next, the range of voltage Vcc at DC supply terminal 10 in Figure 3 can be compared with voltage Vcc at DC supply terminal 10 in Figure 2. Voltage Vcc of DC supply terminal 10 shown in Figure 3 is as follows:

$$Vcc \leqq Vout + Iout \cdot R2 \qquad \text{(Figure 3)}$$

while voltage Vcc of DC supply terminal 10 of the conventional bias circuit shown in Figure 2 is as follows:

$$Vcc \leqq Vout + Vbe2 = Vt \cdot \ln\left(\frac{Iout}{IsQ2}\right) \qquad \text{(Figure 2)}$$

where IsQ2 is the reverse saturation current of transistor 28.

If Vout=1V, Iout=50µA, R2=611Ω, and IsQ1=2.03×10⁻¹⁰µA, the minimum value of voltage Vcc of DC power supply terminal 10 in the embodiment shown in Figure 3 is approximately 1.031V, while the minimum value of voltage Vcc of DC power supply terminal 10 in the conventional bias circuit of Figure 2 is

6

approximately 1.682V. Note that the voltage drops of DC current sources 16 in the circuits of Figures 2 and 3 are ignored. Compared with the conventional circuit, that is to say, a lower minimum value of voltage Vcc from DC power supply terminal 10 is needed in the embodiment shown in Figure 3.

In a configuration such as that of the embodiment described above, therefore, the fluctuation of output voltage Vout in relation to the fluctuations of load current Iout are extremely small, and power consumption is also reduced.

Figure 4 shows a modified form of the embodiment described above, with transistors 26, 28 of the PNP type. In this case, the same effect is obtained by having DC supply terminal 10 and DC current source 16 of the opposite polarities to those in Figure 3. Further in. the explanation given above of the embodiment, transistors 26, 28 were assumed to have matched characteristics, but they can be given different characteristics as may be required, for example by changing the emitter area of transistor 28 in relation to that of transistor 26. Also, needless to say, control of output voltage Vout can be effected by interposing resistances at appropriate points in the circuit of Figure 3.

Figure 5 shows the embodiment described above applied to a current mirror circuit, with the sum of the base currents of transistors 32a. . .32n constituting load current Iout. In this case, since as explained earlier, the fluctuations in load current Iout, i.e. the base current of transistor 26, are very small, an outstandingly good current mirror circuit can be achieved, with minimal dependence on grounded emitter circuit current amplification factors of transistors 26, 28, 32a. . .32n.

**Claims**

1. A bias voltage supply circuit comprising:
a DC power supply terminal (10);
a DC current source (16);
a first transistor (26) connected at its collector to said DC power supply terminal via said DC current source;
a resistor (20) connected between the emitter of said first transistor and a reference potential terminal (14);
a second transistor (28) connected by its collector-emitter circuit in parallel with the series circuit of said DC current source and said first transistor, the base of said second transistor being connected to the collector of said first transistor; and
an output terminal (22) connected to the base of said first transistor, characterised in that the circuit further comprises:
a second resistor (30) connected in parallel with the collector-base circuit of said first transistor.

2. A bias voltage supply circuit according to claim 1, characterised in that the resistance (R2) of said second resistor (30) is given by the equation:

$$R2 = \frac{Vt}{Iout} \cdot \ln \left\{ \frac{Vt \cdot \ln\left(\dfrac{I1}{I1+Iout}\right)}{(I1-Iout) \cdot R1} + \left(\frac{104752}{I1-Iout}\right) \right\}$$

where
Vt=thermal voltage=kT/q,
k=Boltzman's constant,
T=absolute temperature,
q=electron charge,
Iout=output current at said output terminal (22),
I1=current supplied from said DC current source (16),
R1=resistance of said first resistor (20).

**Patentansprüche**

1. Vorspannungsquellenschaltung, mit
einer Gleichstromversorgungs-Anschlußklemme (10),
einer Gleichstromquelle (16),
einem ersten Transistor (26), der an seinem Kollektor über die Gleichstromquelle mit der Gleichstromversorgungs-Anschlußklemme verbunden ist,
einem Widerstand (20), der zwischen den Emitter des ersten Transistors und eine Referenzpotentialklemme (14) geschaltet ist,
einem zweiten Transistor (28), der mit seiner Kollektor/Emitter-Strecke einer Reihenschaltung aus der Gleichstromquelle und dem ersten Transistor parallelgeschaltet ist, wobei die Basis des zweiten Transistors mit dem Kollektor des ersten Transistors verbunden ist, und

7

einer Ausgangsklemme (22), die mit der Basis des ersten Transistors verbunden ist, dadurch gekennzeichnet,

daß die Schaltung desweiteren einer zweiten Widerstand (30) enthält, der der Kollektor/Basis-Strecke des ersten Transistors parallelgeschaltet ist.

2. Vorspannungsquellenschaltung nach Anspruch 1, dadurch gekennzeichnet, daß der Widerstandswert (R2) des zweiten Widerstandes (30) durch die Gleichung

$$R2=\frac{Vt}{Iout} \cdot \ln\left\{ \left(\frac{Vt \cdot \ln\left(\frac{I1}{I1-Iout}\right)}{(I1-Iout) \cdot R1}\right) + \left(\frac{I1+Iout}{I1-Iout}\right) \right\}$$

gegeben ist, wobei

Vt die Thermospannung=kT/q,

k die Boltzman-Konstante,

T die absolute Temperatur,

q die Elektronenladung,

Iout der Ausgangsstrom an der Ausgangsklemme (22),

I1 der Strom, der von der Gleichstromquelle (16) zugeführt wird, und

R1 der Widerstandswert des ersten Widerstandes (20) ist.

**Revendications**

1. Un circuit pour source de tension de polarisation comprenant:

une borne d'alimentation en courant continu (10);

une source de courant continu (16);

un premier transistor (26), connecté, par son collecteur à ladite borne d'alimentation en courant continu par l'intermédiaire de la source de courant continu;

une résistance (20) branchée entre l'émetteur dudit premier transistor et une borne de référence de potentiel (14);

un second transistor (28) connecté par son circuit collecteur-émetteur en parallèle avec le circuit série de ladite source de courant continu et dudit premier transistor, la base dudit second transistor étant connectée au collecteur dudit premier transistor; et

une borne de sortie (22) connectée à la base dudit premier transistors, caractérisé en ce que le circuit comprend encore:

une seconde résistance (30) connectée en parallèle avec le circuit collecteur-base dudit premier transistor.

2. Un circuit pour source de tension de polarisation selon la revendication 1, caractérisé en ce que la valeur (R2) de ladite seconde résistance (30) est donnée par l'équation:

$$R2=\frac{Vt}{Isortie} \cdot \ln\left\{ \frac{Vt \cdot \ln\left(\frac{I1}{I1-Isortie}\right)}{(I1-Isortie) \cdot R1} + \left(\frac{I1+Isortie}{I1-Isortie}\right) \right\}$$

où

Vt=tension thermique=kT/q,

k=constante de Boltzman

T=température absolue,

q=charge de l'électron,

Isortie=courant de sortie sur ladite borne de sortie (22),

I1=courant fourni par ladite source de courant (16),

R1=résistance de ladite première résistance (20).

**0 104 752**

# FIG. 1.
## PRIOR ART

# FIG. 2.
## PRIOR ART

# FIG. 3.

1

FIG. 4.

-Vcc
12

28

26

16

30

22

20

LOAD  24

14

FIG. 5.

10
Vcc

24a  24b  24n

LOAD  LOAD  ---  LOAD

16

30

32a  32b  32n

28  26

22

20

14